# EUROPÄISCHE PATENTANMELDUNG

(11) **EP 0 951 140 A2**
(43) Veröffentlichungstag der Anmeldung: **20.10.1999**
(21) Anmeldenummer: 99102976.0
(22) Anmeldetag: 15.02.1999
(51) Int. Cl.: H03F 3/08, H03F 1/30

(54) **Schaltungsanordnung für einen optischen Empfänger**

(30) Priorität: 18.04.1998 DE 19817283
(71) Anmelder: ROBERT BOSCH GMBH, 70442 Stuttgart (DE)
(72) Erfinder: Thiel, Helmut, 73547 Lorch (DE)

(57) **Zusammenfassung**

Die Erfindung betrifft eine Schaltungsanordnung für einen optischen Empfänger, mit einem optische Signale in elektrische Signale wandelnden Photoelement, einer Verstärkerschaltung zur Verstärkung der elektrischen Signale sowie eine Anordnung zur Einstellung eines Arbeitspunktes der Verstärkerschaltung in Abhängigkeit eines Pegels der optischen Signale.

Es ist vorgesehen, daß das Photoelement (12) mit einem als Transimpedanzverstärker ausgebildeten Vorverstärker verbunden ist, wobei differentielle Ausgänge (k₂, k₃) des Vorverstärkers (16) über einen Regelverstärker (18) mit dem Eingang des Vorverstärkers (16) zu einer signalabhängigen Einstellung des Arbeitspunktes verbunden sind.

## Beschreibung

Die Erfindung betrifft eine Schaltungsanordnung für einen optischen Empfänger mit einem optische Signale in elektrische Signale wandelnden Photoelement, einer Verstärkerschaltung zur Verstärkung der elektrischen Signale sowie eine Anordnung zur Einstellung eines Arbeitspunktes der Verstärkerschaltung in Abhängigkeit des Pegels der optischen Signale.

### Stand der Technik

Schaltungsanordnungen der gattungsgemäßen Art werden beispielsweise in passiven optischen Netzen bei einer Mehrpunkt-zu-Punkt-Übertragung optischer Signale eingesetzt. Hierbei ist ein optischer Netzabschluß über wenigstens eine optische Übertragungsstrecke, die beispielsweise baumartig verzweigt ist, mit einer Vielzahl von optischen Knotenpunkten verbunden. Diese können wiederum mit einer Vielzahl von Einzelteilnehmern verbunden sein. Jeder der Teilnehmer ist in der Lage, über einen optischen Sender optische Signale in das passive optische Netz einzuspeisen. Diese werden zu dem optischen Netzabschluß, einem sogenannten Line Terminal (OLT) geführt und von diesem in elektrische Signale zur weiteren Verarbeitung, Übertragung, Speicherung oder dergleichen gewandelt. Der optische Netzabschluß besitzt einen optischen Empfänger, beispielsweise eine Photodiode, Phototransistor oder dergleichen, mittels dem die über das optische Netz gesandten optischen Signale empfangen werden. Nach Wandlung in elektrische Signale durch das Optoelement werden diese verstärkt und der weiteren Be- beziehungsweise Verarbeitung zugeführt.

Beim Empfang der optischen Signale von den einzelnen Teilnehmern beziehungsweise Knotenpunkten werden diese als sogenannte Burst's (zusammenhängende Signalfolge einer Information) empfangen. Um eine möglichst hohe Übertragungskapazität in dem Netzabschluß zu gewährleisten, ist es erforderlich, die einzelnen Burst's so dicht wie möglich in ihrer zeitlichen Folge zusaummenzufassen. Um dies zu realisieren, muß die Schaltungsanordnung des optischen Empfängers eine große Eingangsempfindlichkeit, eine möglichst hohe Eingangsdynamik, eine geringe Erholzeit (guard-Zeit) sowie eine geringe Einregelzeit aufweisen. Diese Anforderungen an die Schaltungsanordnung sind im wesentlichen abhängig von den über die Übertragungsstrecke empfangenen Burst's. Aufgrund unterschiedlicher Einstellungen der optischen Sender der Burst's, unterschiedlicher Entfernungen der Sender von dem optischen Empfänger weisen die aufeinanderfolgend empfangenen Burst's infolge einer unterschiedlichen Dämpfung unterschiedliche Pegelwerte auf. Ein Arbeitspunkt der Verstärkerschaltung des optischen Empfängers ist auf diese unterschiedlichen Pegelwerte anzupassen.

Hierzu ist bekannt, nach Installation des passiven optischen Netzes eine Eichung vorzunehmen, die die unterschiedlichen erwarteten Pegel der übertragenen Signale berücksichtigt. Hierzu werden die Pegel in einer Einregelphase gemessen und in dem optischen Empfänger gespeichert. Während des Betriebes muß jedes Burstsignal identifiziert und der Arbeitspunkt auf die abgespeicherten Werte eingestellt werden. Hierbei ist nachteilig, daß relativ aufwendige Schaltungen mit einer erheblichen Speicherkapazität zur Verfügung stehen müssen und andererseits während des Betriebes des passiven optischen Netzes auftretende Änderungen in der Dämpfung und somit im Pegel der empfangenen Burstsignale regelmäßig erfaßt und neu abgespeichert werden müssen. Ferner ist bekannt, die Verstärkerschaltung des optischen Empfängers mit einein logarithmischen Verstärker zu realisieren, der auf eine minimale zu erwartende Empfangsleistung (Pegel) abgestimmt wird. Hierbei ist nachteilig, daß logarithmische Verstärker mit einer großen Eingangsdynamik und hoher Grenzfrequenz erforderlich sind, die für eine hohe Übertragungskapazität nicht realisierbar sind.

### Vorteile der Erfindung

Die erfindungsgemäße Schaltungsanordnung mit den im Anspruch 1 genannten Merkmalen bietet den Vorteil, daß in einfacher Weise eine Anpassung an unterschiedliche Signalpegel empfangener Burstsignale möglich ist. Dadurch, daß das Photoelement mit einem als Transimpedanzverstärker ausgebildeten Vorverstärker verbunden ist, wobei differentielle Ausgänge des Transimpedanzverstärkers über einen Regelverstärker mit dem Eingang des Vorverstärkers verbunden sind, läßt sich in einfacher Weise eine mittlere differentielle Ausgangsspannung des Vorverstärkers für jedes eingehende Signal, auch bei unterschiedlichen Pegelwerten, auf Null regeln. Mittels des Regelverstärkers läßt sich eine pegelbezogene Ausgangsdifferenzspannung des Vorverstärkers auf Null regeln, so daß die nachfolgende Be- beziehungsweise Verarbeitung der Signale, insbesondere über einen Breitbandverstärker, unabhängig vom Pegel der empfangenen optischen Signale erfolgen kann. Insbesondere ist durch die Regelung der Ausgangsdifferenzspannung des Vorverstärkers auf Null eine symmetrische Aussteuerung des Vorverstärkers möglich, so daß der Schaltungsanordnung nachfolgende Schaltungsbestandteile nicht mehr auf unterschiedliche Signalpegel ausgelegt zu werden brauchen.

In bevorzugter Ausgestaltung der Erfindung ist vorgesehen, daß der Regelverstärker über eine Diode, insbesondere Schottky-Diode, mit dem Eingang des Vorverstärkers verbunden ist. Hierdurch ergibt sich der Vorteil, daß bei einer geringen Eingangsleistung die Eingangsempfindlichkeit durch den in diesem Fall hochohmigen differentiellen Widerstand der Diode nur unwesentlich beeinträchtigt wird, während bei einer hohen Eingangsleistung aufgrund des dann niederohmigen differentiellen Widerstandes ein Teil des Signalstroms der aus den optischen Signalen gewandelten elektrischen Signale abgeleitet wird. Hierdurch wird insbesondere eine Erhöhung der Eingangsdynamik des Vorverstärkers erreicht.

In weiterer bevorzugter Ausgestaltung der Erfindung ist vorgesehen, daß der Regelverstärker ein Sample-Hold-Verstärker ist. Hierdurch wird vorteilhaft möglich, diesen Regelverstärker durch ein Triggersignal in einen Regelzustand und einen Nichtregelzustand umzuschalten, so daß nach einer Einschwingzeit die Ausgangsdifferenzspannung des Vorverstärkers unabhängig vom Datensignal auf Null regelbar ist.

Weitere vorteilhafte Ausgestaltungen der Erfindung ergeben sich aus den übrigen, in den Unteransprüchen genannten Merkmalen.

### Zeichnungen

Die Erfindung wird nachfolgend in einem Ausführungsbeispiel anhand der zugehörigen Zeichnungen näher erläutert. Es zeigen:
- Figur 1: eine Schaltungsanordnung für einen optischen Empfänger;
- Figur 2: eine schematische Ansicht eines passiven optischen Netzes;
- Figur 3: ein schematischer Signalverlauf von Datensignalen über das optische Netz und
- Figur 4: Signalverläufe der Schaltungsanordnung gemäß Figur 1.

### Beschreibung des Ausführungsbeispiels

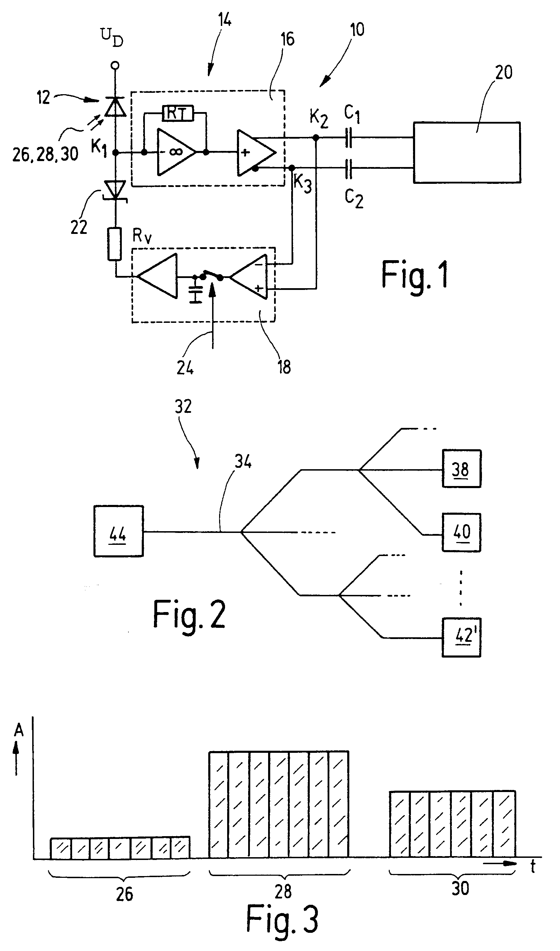

Figur 1 zeigt eine Schaltungsanordnung 10, die Bestandteil eines optischen Empfängers ist. Die Schaltungsanordnung 10 umfaßt ein Photoelement 12, das beispielsweise als Photodiode oder Phototransistor ausgebildet sein kann. Das Photoelement 12 ist mit einer Verstärkerschaltung 14 verbunden, die einen Vorverstärker 16, einen Regelverstärker 18 sowie einen Breitbandverstärker 20 umfaßt. Ein Knotenpunkt k₁ der Schaltungsanordnung 10 ist einerseits mit dem Photoelement 12 und andererseits mit dem Vorverstärker 16 sowie über eine Schottky-Diode 22 mit dem Regelverstärker 18 verbunden. Der Vorverstärker 16 ist als Transimpedanzverstärker ausgebildet, dessen differentielle Ausgänge mit Knotenpunkten k₂ beziehungsweise k₃ verbunden sind. Die Knotenpunkte k₂ und k₃ sind einerseits mit Eingängen des Regelverstärkers 18 und andererseits über Kapazitäten C₁ beziehungsweise C₂ mit dem Breitbandverstärker 20 verbunden. Ein Ausgang des Regelverstärkers 18 ist über einen Vorwiderstand R_{V} mit der Schottky-Diode 22 verbunden. Der Regelverstärker 18 ist mit einem, einen high- oder low-Zustand annehmenden Triggersignal 24 beaufschlagbar. Der Vorverstärker 16 und der Regelverstärker 18 besitzen hier im einzelnen nicht näher bezeichnete Operationsverstärker, deren Aufbau und Funktion allgemein bekannt sind.

Die in Figur 1 gezeigte Schaltungsanordnung 10 zeigt folgende Funktion:

Das Photoelement 12 wandelt empfangene optische Signale 26 in elektrische Signale um. Aufbau und Funktionsweise von Photoelementen sind ebenfalls allgemein bekannt, so daß im Rahmen der folgenden Beschreibung hierauf nicht näher eingegangen werden soll. Die empfangenen optischen Signale 26 sind in Figur 3 beispielhaft gezeigt. Hierbei sind über die Zeit t nacheinanderfolgend drei aus einer Signalfolge von zu übertragenden Daten bestehende, sogenannte Burstsignale 26, 28 beziehungsweise 30, gezeigt. Die Burstsignale 26, 28 und 30 besitzen jeweils einen unterschiedlichen Pegel, wie anhand der über der Zeitachse aufgetragenen Amplitude A erkennbar ist. Diese unterschiedlichen Amplituden A der Burstsignale 26, 28 beziehungsweise 30 können sich beispielsweise aus den geographischen Gegebenheiten eines in Figur 2 schematisch dargestellten passiven optischen Netzes 32 ergeben. Das ausschnittsweise dargestellte optische Netz 32 besitzt eine Übertragungsstrecke 34, die beispielsweise von Glasfaserleitern gebildet ist. Die optische Übertragungsstrecke 34 ist verzweigt aufgebaut, so daß eine Vielzahl von Schaltknoten, sogenannten Network Units (ONU) 38, 40 oder 42 mit einem Netzabschluß, einem sogenannten Line Terminal 44 (OLT) verbunden sind. Der Line Terminal 44 besitzt einen optischen Empfänger, der die in Figur 1 gezeigte Schaltungsanordnung 10 umfaßt. Die Network Units 38, 40 und 42 besitzen jeweils optische Sender, über die die Burstsignale 26, 28 und 30 über die Übertragungsstrecke 34 zum Line Terminal 44 übertragbar sind. Entsprechend einer Entfernung der Network Units 38, 40 und 42 vom Line Terminal 44 besitzt die Übertragungsstrecke 34 eine unterschiedliche Dämpfung, so daß die Burstsignale 26, 28 und 30 (Figur 3) unterschiedliche Signalpegel, das heißt Amplituden A, aufweisen.

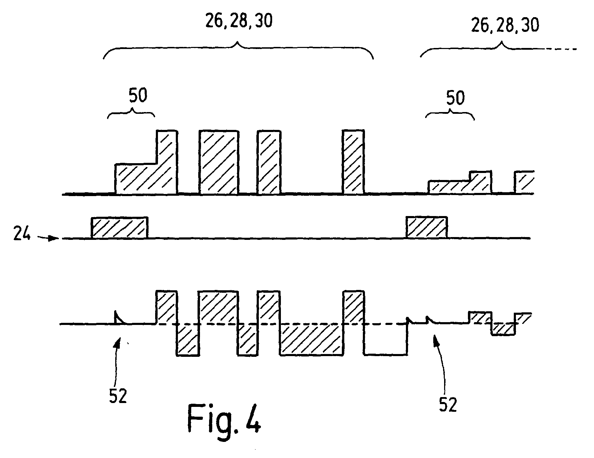

Das Regelverhalten der Schaltungsanordnung 10 erfolgt nunmehr in der Weise, daß abhängig von einem gerade auf das Photoelement 12 treffenden Burstsignal 26, 28 oder 30 eine mittlere differentielle Ausgangsspannung des Vorverstärkers 16 auf Null geregelt wird. Diese Regelung erfolgt mit Auftreffen des Burstsignals 26, 28 oder 30 auf das Photoelement 12. Diese Regelung muß vor den zu empfangenden und zu verstärkenden und weiterzugebenden Datensignalanteilen der Burstsignale 26, 28 und 30 abgeschlossen sein. Hierzu besitzen die Burstsignale 26, 28 beziehungsweise 30 an ihrem Signalanfang, wie in der oberen Zeitachse der Figur 4 verdeutlicht wird, einen Signalbereich 50, in dem zunächst eine halbe Spitzenleistung (halber Pegel) der zu übertragenden Burstsignale 26, 28 beziehungsweise 30 gesendet wird. Die halbe Spitzenleistung des Bereiches 50 unterliegt der gleichen Dämpfung wie die nachfolgenden Datensignalanteile eines jeden Burstsignales 26, 28 beziehungsweise 30.

Dieser Bereich 50 mit der halben Spitzenleistung dient der Einschwingung des Regelverstärkers 18 in Abhängigkeit des Anliegens des Triggersignals 24, das in der zweiten Zeitachse der Figur 4 dargestellt ist. Das Triggersignal 24 besitzt entweder den Zustand high oder den Zustand low. Während des Empfangens des Bereiches 50 der Burstsignale wird das Triggersignal 24 in den Zustand high geschaltet, so daß der Regelkreis über den Vorverstärker 16 und den Regelverstärker 18 sowie die Schottky-Diode 22 mit Vorwiderstand R_{V} geschlossen ist. Hier gelangt eine Stellgröße des Regelverstärkers 18 über die Schottky-Diode 22 an den Knotenpunkt k₁ und somit den Eingang des Vorverstärkers 16. Ist die Regelung eingeschwungen, wobei das Einschwingen des Signals des Vorverstärkers 18 in der dritten Zeitachse der Figur 4 dargestellt ist (Bereiche 52), fließt der der mittleren Empfangsleistung (Bereich 50) entsprechende Strom als Stellgröße an den Eingang des Vorverstärkers 16, und der Eingangsstrom des Vorverstärkers 16 wird Null. Dieser Regelzustand wird für die Übertragungsdauer der einzelnen Burstsignale 26, 28 beziehungsweise 30 aufrechterhalten. Dies geschieht entweder über den Regelverstärker 18, wie nachfolgend noch erläutert wird, oder über eine Regelzeitkonstante, die den eingeschwungenen Zustand zumindest bis zum Empfang des nächsten Burstsignals mit seinem Bereich 50 konstant hält. Die nachfolgende Vorverstärkung der Datensignalanteile der Burstsignale 26, 28 beziehungsweise 30 erfolgt symmetrisch zum Nullpunkt entsprechend der empfangenen high- beziehungsweise low-Pegel der Burstsignale. Im Vergleich der Signalverläufe in der oberen Zeitachse (Burstsignale) und der unteren Zeitachse (Ausgangssignale des Vorverstärkers 16) wird deutlich, daß der Pegel entsprechend der im Bereich 50 empfangenen mittleren Pegelleistung in Richtung zum Nullpunkt verschoben wird, so daß die Ausgangssignale des Vorverstärkers 16 symmetrisch um den Nullpunkt schwanken. Durch diese symmetrische Schwankung um den Nullpunkt ergibt sich ferner eine Verdopplung der Übersteuerungsfestigkeit des Vorverstärkers 16 im Vergleich zu einer einseitig des Nullpunktes liegenden Aussteuerung.

Das in der unteren Zeitachse der Figur 4 dargestellte Ausgangssignal des Vorverstärkers 16 liegt einerseits über die Knotenpunkte k₂, k₃ am Regelverstärker 18 und andererseits an den Kapazitäten C₁ und C₂ an. Da die mittlere Ausgangsspannung gemäß der erläuterten Regelung immer Null ist, kann eine kapazitive Kopplung über die Kapazitäten C₁, C₂ der Datensignale in einfacher und bekannter Weise zu dem Breitbandverstärker 20 erfolgen.

Die Stellgröße des Regelverstärkers 18 wird über den Vorwiderstand R_{V} und die Schottky-Diode 22 an den Eingang des Vorverstärkers 16 rückgeführt. Hierdurch ist ein Empfindlichkeitsverlust bei kleinen Empfangsleistungen (kleine Amplitude A) der Burstsignale gering. Bei großen Empfangsleistungen (große Amplitude A) der Burstsignale muß ein relativ großer mittlerer Steuerstrom durch die Schottky-Diode 22 fließen, wobei der differentielle Widerstand der Schottky-Diode 22 abnimmt. Dieser differentielle Widerstand liegt für den Signalstrom des Photoelementes 12 parallel zum Eingang des Vorverstärkers 16 und leitet einen Teil des Signalstroms ab. Bei geeigneter Dimensionierung des Vorwiderstandes R_{V} läßt sich somit die Eingangsdynamik des Vorverstärkers 16 stark erhöhen.

Der Regelverstärker 18 ist ein sogenannter Sample/Hold-Verstärker, der durch das Triggersignal 24 gesteuert wird. Ist der Regelverstärker 18 durch das Triggersignal auf "Sample" geschaltet (Triggersignal 24 hat den Zustand high), ist der Offsetregelkreis des Vorverstärkers 16 geschlossen und die Ausgangsoffsetspannung zwischen den Knotenpunkten k₂ und k₃ des Vorverstärkers 16 wird nach einer Einschwingzeit (Bereich 52, Figur 4) unabhängig vom anliegenden Datensignal auf Null geregelt. Fließt während dieser Zeitspanne ein Strom über die Schottky-Diode 22, der der mittleren Datensignalleistung des zu empfangenden Burstsignals (Bereiche 50 der Burstsignale) entspricht, dann ist die differentielle Ausgangsspannung des Vorverstärkers 16 für eine mittlere Signalleistung Null, so daß entsprechend der nachfolgend empfangenen Datensignalanteile der Burstsignale 26, 28 und 30 die Ausgangsspannung des Vorverstärkers 16 symmetrisch um den Nullpunkt schwankt (Verlagerung um die halbe Signalleistung in beziehungsweise unter den Nullpunkt). Ist der Regelverstärker 18 auf "hold" geschaltet (Triggersignal 24 besitzt den low-Zustand), behält der Regelverstärker 18 seinen Regelzustand bei, das heißt, die high- beziehungsweise low-Pegel der Datensignalanteile werden weiter symmetrisch um den Nullpunkt ausgesteuert. Auch ist es möglich, im hold-Zustand den Regelverstärker nicht abzuschalten, sondern mit einer so großen Regelzeitkonstante zu betreiben, die das Datensignal nicht beeinflußt (dieser Schaltungsteil ist nicht dargestellt). Dadurch wird es möglich, beliebig lange Burst's zu empfangen.

Im Bereich 50 des Burstsignals wird die Signalform während einer Einregelzeit der Schaltungsanordnung 10 statisch auf einen Pegel mit halber Spitzenleistung gehalten. Hierdurch wird innerhalb kürzester Zeit eine Einregelung auf den Nullpunkt möglich. Nach einer weiteren Variante kann anstelle des statischen Bereiches 50 eine high-low-Folge des Burstsignals gesendet werden, innerhalb der ein Einschwingen der Schaltungsanordnung 10 auf einen Mittelwert dieser high-low-Folge erfolgen kann. Das nachfolgende Halten des Vorverstärkers 16 auf die symmetrische Aussteuerung um den Nullpunkt bleibt dann wie bereits erläutert erhalten.

Insgesamt wird es somit mit einfachen schaltungstechnischen Maßnahmen möglich, bei Empfang eines jeden Burstsignals 26, 28 und 30 zu Beginn des Empfangs mittels einer festgelegten Anfangs-Signalform des Burstsignals die Ausgangsdifferenzspannung des Vorverstärkers 16 auf Null zu regeln. Lediglich während dieser Einregelzeit muß der Regelverstärker 18 durch ein Triggersignal 24 aktiv geschaltet sein. Nachdem die Einregelung der Schaltungsanordnung 10 abgeschlossen ist, kann die Regelung über die Restlaufzeit der Burstsignale 26, 28 und 30 entweder konstant gehalten werden oder mit einer so großen Zeitkonstante versehen werden, daß die Datensignalanteile der Burstsignale nicht beeinflußt werden.

Insbesondere wird durch die einfache Einregelung des Vorverstärkers 16 auf eine differentielle Ausgangsspannung von Null eine symmetrische Aussteuerung des Vorverstärkers 16 entsprechend der anliegenden Pegel der Datensignalanteile der Burstsignale möglich. Hierdurch ist bei den nachfolgenden Schaltungsbestandteilen, beispielsweise dem Breitbandverstärker 20, eine zusätzliche Anpassung an unterschiedliche Pegel der Burstsignale 26, 28 und 30 nicht mehr notwendig.

Durch die Verwendung der Schottky-Diode 22 als Verbindung zwischen dem Ausgang des Regelverstärkers und dem Eingang des Vorverstärkers 16 ergibt sich, daß bei einer geringen Eingangsleistung die Eingangsempfindlichkeit durch den in diesem Fall hochohmigen differentiellen Widerstand der Schottky-Diode 22 kaum beeinträchtigt wird, während bei hohen Eingangsleistungen, aufgrund eines nur niederohmigen differentiellen Widerstandes der Schottky-Diode 22 ein Teil des Signalstromes des Photoelementes 22 abgeleitet wird. Für die Dimensionierung des als Transimpedanzverstärkers ausgebildeten Vorverstärkers 16 ergibt sich hierdurch, daß die Transimpedanz für geringe Eingangsleistungen optimiert werden kann, das heißt ein möglichst hoher Transimpedanzwiderstand gegeben ist. Beim Empfang hoher Pegel bewirkt die SchottkyDiode mit ihrem geringen differentiellen Widerstand, daß ein Teil des Signalstroms am Eingang des Vorverstärkers 16 abgeleitet wird und somit dieser nicht übersteuert wird.

## Patentansprüche

1. Schaltungsanordnung für einen optischen Empfänger, mit einem optische Signale in elektrische Signale wandelnden Photoelement, einer Verstärkerschaltung zur Verstärkung der elektrischen Signale sowie eine Anordnung zur Einstellung eines Arbeitspunktes der Verstärkerschaltung in Abhängigkeit eines Pegels der optischen Signale, **dadurch gekennzeichnet**, daß das Photoelement (12) mit einem als Transimpedanzverstärker ausgebildeten Vorverstärker verbunden ist, wobei differentielle Ausgänge (k₂, k₃) des Vorverstärkers (16) über einen Regelverstärker (18) mit dem Eingang des Vorverstärkers (16) zu einer signalabhängigen Einstellung des Arbeitspunktes verbunden sind.

2. Schaltungsanordnung nach Anspruch 1, **dadurch gekennzeichnet**, daß ein Ausgang des Regelverstärkers (18) über eine Diode mit dem Eingang des Vorverstärkers (16) verbunden ist.

3. Schaltungsanordnung nach Anspruch 2, **dadurch gekennzeichnet**, daß die Diode eine Schottky-Diode (22) ist.

4. Schaltungsanordnung nach einem der vorhergehenden Ansprüche, **dadurch gekennzeichnet**, daß der Regelverstärker (18) ein Sample/Hold-Verstärker ist.

5. Schaltungsanordnung nach einem der vorhergehenden Ansprüche, **dadurch gekennzeichnet**, daß der Sample/Hold-Verstärker mit einem Triggersignal (24) beaufschlagbar ist, mittels dem der Sample/Hold-Verstärker in einem Einschwingzustand und einen Haltezustand der Schaltungsanordnung umschaltbar ist.

6. Schaltungsanordnung nach einem der vorhergehenden Ansprüche, **dadurch gekennzeichnet**, daß mittels des Regelverstärkers (18) eine mittlere differentielle Ausgangsspannung des Vorverstärkers (16) in Abhängigkeit des Empfangs eines optischen Signales (26, 28, 30) auf Null regelbar ist.

7. Schaltungsanordnung nach einem der vorhergehenden Ansprüche, **dadurch gekennzeichnet**, daß das optische Signal (26, 28, 30) einen Datensignalanteilen vorgelagerten Bereich (50) umfaßt, der dem Einschwingen der Schaltungsanordnung (10) dient.

8. Schaltungsanordnung nach einem der vorhergehenden Ansprüche, **dadurch gekennzeichnet**, daß der Bereich (50) über eine wählbare Zeitspanne (t) ein Signal mit halbem Pegel der Datensignalanteile bereitstellt.

9. Schaltungsanordnung nach einem der vorhergehenden Ansprüche, **dadurch gekennzeichnet**, daß der Bereich (50) die Folge eines maximalen und eines minimalen Pegels der Datensignalanteile liefert.

10. Schaltungsanordnung nach einem der vorhergehenden Ansprüche, **dadurch gekennzeichnet**, daß nach Einschwingen der Schaltungsanordnung (10) der erreichte Zustand durch Umschaltung des Sample/Hold-Verstärkers in den Haltezustand haltbar ist.

11. Schaltungsanordnung nach einem der vorhergehenden Ansprüche, **dadurch gekennzeichnet**, daß nach Einschwingen der Schaltungsanordnung (10) der erreichte Zustand mittels einer Regelung mit ausreichend großer Regelzeitkonstante gehalten wird.

12. Schaltungsanordnung nach einem der vorhergehenden Ansprüche, **dadurch gekennzeichnet**, daß die Schaltungsanordnung (10) Bestandteil eines Netzabschlusses (44) eines passiven optischen Netzes (32) ist.
